Europäisches Patentamt

European Patent Office

Office européen des brevets

(11) Publication number: **0 165 538 B1**

# EUROPEAN PATENT SPECIFICATION

(45) Date of publication of patent specification: 04.09.91  (51) Int. Cl.⁵: **H01L 21/31**

(21) Application number: 85107135.7

(22) Date of filing: 11.06.85

(54) A resistor for a group III-V intermetallic compound semiconductor integrated circuit.

(30) Priority: 22.06.84 US 623820

(43) Date of publication of application:
27.12.85 Bulletin 85/52

(45) Publication of the grant of the patent:
04.09.91 Bulletin 91/36

(84) Designated Contracting States:
DE FR GB

(56) References cited:
EP-A- 0 090 963

GaAs IC SYMPOSIUM TECHNICAL DIGEST,
Phoenix, Arizona, 25th -27th October 1983,
pages 170-173, IEEE; P.M. ASBECK et al.:
"Emitter-coupled logic circuits implemented
with heterojunction bipolar transistors"

(73) Proprietor: International Business Machines
Corporation
Old Orchard Road
Armonk, N.Y. 10504(US)

(72) Inventor: Hovel, Harold John
Diane Court
Katonah New York 10536(US)

(74) Representative: Burt, Roger James, Dr.
IBM United Kingdom Limited Intellectual
Property Department Hursley Park
Winchester Hampshire SO21 2JN(GB)

Rank Xerox (UK) Business Services

## Description

This invention relates to a resistor formed in a Group III-V intermetallic compound semiconductor integrated circuit.

As the density of devices in integrated circuits increases, the physical area available for a resistor circuit component becomes progressively smaller and in the case of integrated circuits, involving intermetallic semiconductors, such as GaAs and the alloys of Ga, As and another element, the elements of the semiconductor crystal may react with and have property altering effects on the resistor which together limit flexibility in resistance variation and physical size.

The effect of semiconductor influencing impurities on a semiconductor resistor is taught in US-A-3,248,677 where impurities of different types are employed to compensate for temperature variation.

The present practice in the intermetallic compound semiconductor integrated circuit art is to provide resistors out of deposited refractory materials such as TaN and TiN as is described in Thin Solid Films 8, (1971) 81-100. These materials, however, have limitations in that they have very small sheet resistances which in turn, limits circuit design and they can develop cracks and craze due to stress.

A resistor formed on a Group III-V intermetallic compound semiconductor integrated circuit comprises, according to the invention, a layer of doped Group IV semiconductor material.

How the invention can be carried out will now be described by way of example, with reference to the accompanying drawings, in which:-

FIG.1 represents a resistor bridging two active devices formed in an intermetallic semiconductor substrate; and

FIG.2 represents the deposition of material to form a resistor for an intermetallic semiconductor integrated circuit.

The invention is concerned with the provision of an improved resistor element for use in an intermetallic semiconductor integrated circuit. The resistor is made of a group IV element that is compatible with the processing and use conditions to which the intermetallic integrated circuit may be subjected. These elements, in the practical sense at the current state of the art, include germanium and silicon and would also include the diamond allotropic form of carbon and the form of tin known as "grey tin". The diamond and grey tin forms have cost and temperature limitations at this time that make the germanium and silicon the more attractive candidates for present day integrated circuits.

In providing a resistor in an integrated circuit, there are constraints on the area and thickness of the resistor element that are determined by the density and wiring of the integrated circuit so that the ability to vary the resistivity of the material used for the resistor becomes of greater importance. In addition, the resistor once positioned must be resistant to the effect of processing steps in integrated circuit formation. The processing steps, such as diffusion, chemical vapor depostion, and annealing, frequently cause elements to move into or out of the resistor, changing the resistive value and possibly affecting adjacent elements in the substrate and where chemical reactions take place, even a change in size may occur. Where the intermetallic semiconductor is a compound where one element has a property such as volatility or high diffusivity, such as is the situation with GaAs or GaA1As, a resistor that accommodates all the problems is difficult to provide.

It has been found that the group IV elements, germanium and silicon, can be doped to achieve the desired resistivity $\rho$ that the resistivity variation under use and processing conditions can be accommodated with doping and that elements from, eg the gallium arsenide, crystal merely serve as dopants in the resistor. While resistive elements can be provided directly within the III-V intermetallic compound, solid solubilities of common dopants are much greater in the group IV elements and therefore greater resistivity adjustment flexibility using Ge or Si is achieved.

The resistor element can be co-deposited along with a resistivity controlling dopant or it may be a separately deposited germanium or silicon member implanted with a dopant. Strain and cracking is minimized because the lattice spacing of the germium and silicon is not greatly different from that of the III-V intermetallic substrate such as GaAs and conductivity type affecting impurities such as boron in the germanium or silicon generally provide insulating properties to the GaAs.

The solubility of the III-V intermetallic ingredients, particularly arsenic, in germanium and silicon is an order of magnitude higher than most n-type dopants in GaAs. This results in much wider sheet resistance flexibility and therefore potentially smaller circuit elements. Since arsenic is an elemental constituent of the GaAs, the deposition of arsenic doped germanium or silicon or the ion implantation of arsenic into germanium or silicon resistance layers on GaAs will not adversely affect the GaAs. Other dopants such as boron can also be employed in the germanium or silicon resistor. For simultaneous device isolation of the GaAs integrated circuit coupled with p-type resistor formation, the materials germanium and silicon are easily etched by solutions or gases that do not etch GaAs. This leads to high selectivity in wet chemical or plasma etching of the resistor elements. The

3 EP 0 165 538 B1 4

heavily doped germanium or silicon elements are less sensitive to light than GaAs elements and much less sensitive to the effect of deep level traps both in the germanium or silicon and at the interface due to the very small band gap of the germanium and silicon. Where the resistor element is polycrystalline, there is a further reduction of optical effects.

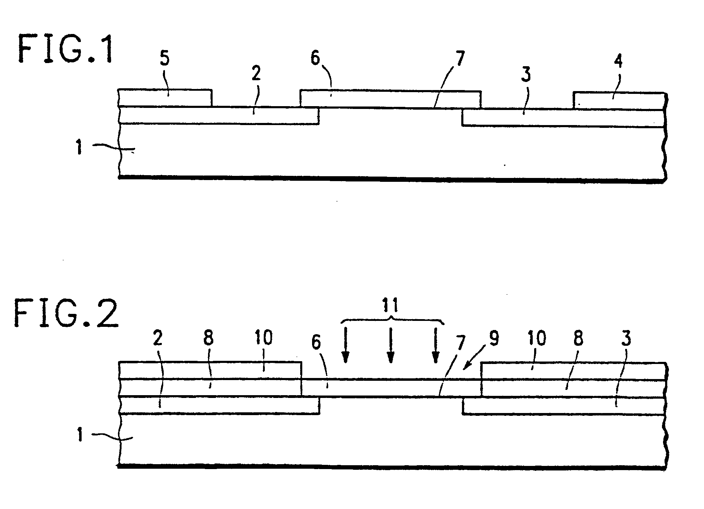

Referring to FIG. 1, there is shown a GaAs substrate 1 having in the upper surface thereof regions 2 and 3 of active devices, only the external ohmic contacts 4 and 5 of which are shown. A resistive member 6 is shown positioned on the surface 7 of the substrate 1 joining the two active regions 2 and 3.

In accordance with the invention, the resistive member 6 is made of a Group IV material. The regions 2 and 3 may be the source and drain electrodes of an FET transistor or the emitter, base or collector of a bipolar transistor.

The structure of FIG. 2 illustrates the formation of the resistor 6 on the intermetallic semiconductor substrate 1 employing identical reference numerals for identical elements with FIG. 1.

A resist layer 8 is applied over the surface 7 of the substrate 1 and an opening 9 is formed in the resist layer to expose a portion of the surface 7. A layer 10 of Si or Ge is deposited over the resist layer 8, but this is later removed when the resist layer 8 is removed. If the material of the resist pattern 8 is made up of a material other than resist, such as $SiO_2$, it may be removed to leave just the resistor element 6.

In a deposition as indicated by the arrows 11, the element for the resistor 6 along with appropriate doping for resistivity control may be co-deposited.

The resistive element 6 is formed on the surface 7 usually as part of other processing steps and is then transformed into a selected appropriate resistivity by such techniques as doping with ion implantation or diffusion employing, for example, one of the elements As, B, P, In, Ga or A1. The element 6 may be single crystal or polycrystalline. A mask, not shown, would be employed to prevent the ion implantation or dopant introduction from producing unwanted effects in adjacent regions.

Through the use of arsenic ion implantation or diffusion doping, the Group IV resistive element 6 becomes n conductivity type whereas the arsenic has no significant effect on the GaAs substrate. Similarly, where the ion implantation is with boron, p conductivity type is imparted to the element 6 and the boron introduces insulating properties into unmasked portions of the GaAs substrate 1.

In a preferred embodiment, referring to FIG. 1, the substrate 1 is of GaAs and the resistive element 6 is of Ge doped with tin. The germanium is vapour deposited onto the surface 7 of the substrate using either resistance heating or by electron beam. Since the vapor pressure of tin is substantially the same as germanium and since tin has a very high solubility in germanium, a germanium film 6 with controlled tin quantities may be obtained by mixing undoped germanium with measured amounts of tin and co-vapour depositing them from the same boat. Evaporation to completion may be employed to ensure final film composition reproducibility that is proportional to the starting mixture. The substrate temperature can be used to further tailor film properties and reproducibility through grain size modification.

What has been described is the use Of a doped Group IV semiconductor region as a resistor for a Group III-V intermetallic compound semiconductor integrated circuit.

## Claims

1. A resistor (6) formed on a Group III-V intermetallic compound semiconductor integrated circuit (1, 2, 3), characterised in that the resistor is formed of a layer of doped Group IV semiconductor material.

2. A resistor as claimed in claim 1, which is formed of doped germanium.

3. A resistor as claimed in claim 2, which is formed on a GaAs integrated circuit and in which the germanium is doped with tin.

4. A resistor as claimed in claim 3, formed by co-depositing tin and germanium on the GaAs.

5. A resistor as claimed in claim 1, which is formed of doped silicon.

6. A resistor as claimed in claim 5, which is formed on a GaAs integrated circuit and in which the silicon is doped with tin.

7. A resistor as claimed in any of claims 1, 2 and 5, in which the Group IV semiconductor material is doped with Sn, As, B, P, In, Ga, or Al.

8. A resistor as claimed in any of claims 1, 2, 5 and 7, in which the Group IV semiconductor material is doped by the technique of ion implantation.

9. A resistor as claimed in any of claims 1, 2, 5 and 7, in which the Group IV semiconductor material is doped by the technique of diffusion.

**Revendications**

3

1. Résistance (6) formée sur un circuit intégré semi-conducteur en composé intermétallique de groupe III-V (1,2,3), caractérisée en ce que la résistance est formée d'une couche de matière semi-conductrice du groupe IV dopée.

2. Résistance suivant la revendication 1, qui est formée de germanium dopé.

3. Résistance suivant la revendication 2, qui est formée sur un circuit intégré en GaAs et dans laquelle le germanium est dopé avec de l'étain.

4. Résistance suivant la revendication 3, formée par co-dépôt d'étain et de germanium sur le GaAs.

5. Résistance suivant la revendication 1, qui est formée de silicium dopé.

6. Résistance suivant la revendication 5, qui est formée sur un circuit intégré en GaAs et dans laquelle le silicium est dopé avec de l'étain.

7. Résistance suivant l'une quelconque des revendications 1,2 et 5, dans laquelle la matière semi-conductrice du groupe IV est dopée avec Sn, As, B, P, In, Ga ou Al.

8. Résistance suivant l'une quelconque des revendications 1, 2, 5 et 7, dans laquelle la matière semi-conductrice du groupe IV est dopée par la technique d'implantation d'ions.

9. Résistance suivant l'une quelconque des revendications 1, 2, 5 et 7, dans laquelle la matière semi-conductrice du groupe IV est dopée par la technique de diffusion.

**Patentansprüche**

1. Widerstand (6), der auf einem integrierten intermetallischen III-V Verbindungshalbleiter-Schaltkreis (1,2,3) ausgebildet ist, dadurch gekennzeichnet, daß der Widerstand aus einer Schicht aus dotiertem Halbleitermaterial der Gruppe IV ausgebildet ist.

2. Widerstand nach Anspruch 1, der aus dotiertem Germanium ausgebildet ist.

3. Widerstand nach Anspruch 2, der auf einem integrierten GaAs Schaltkreis ausgebildet ist und bei welchem das Germanium mit Zinn dotiert ist.

4. Widerstand nach Anspruch 3, der durch gemeinsames Aufbringen von Zinn und Germanium auf das GaAs ausgebildet ist.

5. Widerstand nach Anspruch 1, der aus dotiertem Silizium ausgebildet ist.

6. Widerstand nach Anspruch 5, welcher auf einem integrierten GaAs Schaltkreis ausgebildet ist und bei welchem das Silizium mit Zinn dotiert ist.

7. Widerstand nach irgendeinem der Ansprüche 1, 2 und S, bei welchem das Halbleitermaterial der Gruppe IV mit Sn, As, B, P, In, Ga oder Al dotiert ist.

8. Widerstand nach irgendeinem der Ansprüche 1, 2, 5 und 7, bei welchem das Halbleitermaterial der Gruppe IV mittels der Ionenimplantationstechnik dotiert ist.

9. Widerstand nach irgendeinem der Ansprüche 1, 2, 5 und 7, bei welchem das Halbleitermaterial der Gruppe IV mittels der Diffusionstechnik dotiert ist.

## FIG.1

## FIG.2